(19) Europäisches Patentamt
European Patent Office
Office européen des brevets

(11) **EP 4 498 779 A1**

(12) **EUROPEAN PATENT APPLICATION**

(43) Date of publication:
**29.01.2025 Bulletin 2025/05**

(21) Application number: **24179135.9**

(22) Date of filing: **30.05.2024**

(51) International Patent Classification (IPC):
**H10K 50/19** (2023.01)      **H10K 50/818** (2023.01)
**H10K 50/852** (2023.01)      **H10K 59/35** (2023.01)
**H10K 59/38** (2023.01)      **H10K 59/80** (2023.01)
**H10K 50/13** (2023.01)      H10K 102/00 (2023.01)

(52) Cooperative Patent Classification (CPC):
**H10K 59/38; H10K 50/13; H10K 59/35;
H10K 59/80518; H10K 59/876;** H10K 50/19;
H10K 2102/3026; H10K 2102/351

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **24.07.2023 KR 20230096415**

(71) Applicant: **Samsung Display Co., Ltd.
Yongin-si, Gyeonggi-do 17113 (KR)**

(72) Inventors:
• **KO, Hyomin**
  **17113 Yongin-si (KR)**
• **LEE, Bora**
  **17113 Yongin-si (KR)**
• **IM, Hyeonjeong**
  **17113 Yongin-si (KR)**

(74) Representative: **Marks & Clerk LLP
15 Fetter Lane
London EC4A 1BW (GB)**

(54) **DISPLAY APPARATUS**

(57)    A display apparatus includes: a circuit layer on a substrate, a pixel electrode on the circuit layer, an intermediate layer on the pixel electrode and including a first emission layer, a second emission layer, a third emission layer, and a fourth emission layer, an opposite electrode on the intermediate layer, a color filter layer on the opposite electrode and including a first color filter, a second color filter, and a third color filter, and an optical auxiliary layer between the pixel electrode and the intermediate layer, wherein a thickness of each of layers included in the intermediate layer and a thickness of each of optical auxiliary layers included in the optical auxiliary layer are optimized.

FIG. 6

EP 4 498 779 A1

**Description**

**BACKGROUND**

**1. Field**

Aspects of one or more embodiments relate to a display apparatus.

**2. Description of the Related Art**

A display apparatus is an apparatus that displays an image by receiving information about an image. Display apparatuses can be used as a display part of small products, such as mobile phones, or as a display part of large products, such as televisions.

A display apparatus includes a plurality of pixels that receive an electrical signal and emit light to display an image externally. Each pixel includes a light-emitting element, and for example, in the case of an organic light-emitting display, each pixel includes an organic light-emitting diode (OLED) as the light-emitting element. In general, in an organic light-emitting display apparatus, a thin-film transistor and an organic light-emitting diode are formed on a substrate, and the organic light-emitting diode itself emits light.

In addition, many researches are in progress to increase the light efficiency of these display apparatuses.

The above information disclosed in this Background section is only for enhancement of understanding of the background and therefore the information discussed in this Background section does not necessarily constitute prior art.

**SUMMARY**

Aspects of one or more embodiments relate to a display apparatus, and for example, to a display apparatus having relatively high light efficiency.

Aspects one or more embodiments include a display apparatus having relatively high light efficiency. However, these characteristics are merely illustrative, and the scope of embodiments according to the present disclosure are not limited thereto.

Additional aspects will be set forth in part in the description which follows and, in part, will be apparent from the description, or may be learned by practice of the presented embodiments of the disclosure.

According to some embodiments, a display apparatus includes a circuit layer on a substrate, a pixel electrode on the circuit layer, an intermediate layer on the pixel electrode and including a first emission layer, a second emission layer, a third emission layer, and a fourth emission layer, an opposite electrode on the intermediate layer, a color filter layer on the opposite electrode and including a first color filter which is on the opposite electrode and through which light in the second wavelength band transmits, a second color filter side-by-side with the first color filter and through which light in the third wavelength band transmits, and a third color filter side-by-side with the second color filter and through which light in the first wavelength band transmits, and an optical auxiliary layer between the pixel electrode and the intermediate layer and including a first optical auxiliary body having a first thickness, and a second optical auxiliary body side-by-side with the first optical auxiliary body and having a second thickness greater than the first thickness, wherein the first optical auxiliary body and the first color filter overlap each other in a plan view, and the second optical auxiliary body and the third color filter overlaps each other in a plan view.

According to some embodiments, the intermediate layer may further include a first hole transport layer between the pixel electrode and the first emission layer.

According to some embodiments, the sum of an optical thickness of the first hole transport layer in the first wavelength band and an optical thickness of the second optical auxiliary body in the first wavelength band may coincide with the sum of an optical thickness of the first hole transport layer in the second wavelength band and an optical thickness of the first optical auxiliary body in the second wavelength band.

According to some embodiments, the optical thickness of the first hole transport layer in the first wavelength band may be in inverse proportion to the optical thickness of the second optical auxiliary body in the first wavelength band.

According to some embodiments, a part of the first hole transport layer in the first wavelength band may be replaceable with a part of the second optical auxiliary body in the first wavelength band.

According to some embodiments, an optical thickness of a part of the first hole transport layer in the first wavelength band may coincide with an optical thickness of a part of the second optical auxiliary body in the first wavelength band.

According to some embodiments, the pixel electrode may include a reflective layer on the substrate and a first transparent conductive layer on the reflective layer, and the optical auxiliary layer may be between the first transparent conductive layer and the intermediate layer.

According to some embodiments, the pixel electrode may further include a second transparent conductive layer under the reflective layer, and an upper surface of the second transparent conductive layer and a lower surface of the reflective layer may be in contact with each other.

According to some embodiments, a difference between the second thickness and the first thickness may be greater than a thickness of the first emission layer.

According to some embodiments, a thickness of the first emission layer may coincide with a thickness of the fourth emission layer.

According to some embodiments, the first wavelength band may be a blue-based visible light region, the second wavelength band may be a red-based visible light region, and the third wavelength band may be a green-based visible light region.

According to some embodiments, a first connection layer may be between the first emission layer and the second emission layer, and a second connection layer may be between the third emission layer and the fourth emission layer.

According to some embodiments, a thickness of the first connection layer and a thickness of the second connection layer may be greater than a thickness of the first emission layer.

According to some embodiments, the first connection layer may include a first electron transport layer on the first emission layer, a first charge generation layer on the first electron transport layer, and a second hole transport layer on the first charge generation layer.

According to some embodiments, the second connection layer may include a second electron transport layer on the third emission layer, a second charge generation layer on the second electron transport layer, and a third hole transport layer on the second charge generation layer.

According to some embodiments, an upper surface of the second emission layer and a lower surface of the third emission layer may be in contact with each other.

According to some embodiments, a capping layer may be further between the opposite electrode and the color filter layer.

According to some embodiments, a difference between the second thickness and the first thickness may be about 120 Å to about 180 Å.

According to some embodiments, the optical auxiliary layer may further include a third optical auxiliary body having a third thickness and side-by-side with the first optical auxiliary body and the second optical auxiliary body.

According to some embodiments, the third thickness may be less than the first thickness and the second thickness.

According to some embodiments, a difference between the third thickness and the second thickness may be about 900 Å to about 1020 Å.

According to some embodiments, a difference between the second thickness and the third thickness may be six times the difference between the first thickness and the second thickness.

According to some embodiments, in a plan view, the third optical auxiliary body may overlap the second color filter.

According to some embodiments, a thickness of the intermediate layer may be about 2200 Å to about 2800 Å.

At least some of the above and other features of the invention are set out in the claims.

## BRIEF DESCRIPTION OF THE DRAWINGS

The above and other aspects, features, and characteristics of certain embodiments of the disclosure will be more apparent from the following description taken in conjunction with the accompanying drawings, in which:

FIG. 1 is a plan view schematically illustrating a display panel of a display apparatus according to an embodiment;
FIG. 2 is an equivalent circuit diagram of one pixel of the display panel of FIG. 1;
FIG. 3 is a cross-sectional view schematically a part of the display panel of FIG. 1;
FIG. 4 is a conceptual diagram schematically illustrating a cross-section of an intermediate layer of FIG. 3;
FIG. 5 is a graph illustrating an index of refraction of an optical auxiliary layer of FIG. 3 and an index of refraction of a first hole transport layer of FIG. 4;
FIG. 6 is a cross-sectional view schematically illustrating an example of a stack structure of a pixel electrode, an optical auxiliary layer, an intermediate layer, a capping layer, and a color filter layer of FIG. 3;
FIGS. 7 through 9 are tables showing light efficiency according to each wavelength band in the example of FIG. 6;
FIG. 10 is a cross-sectional view schematically illustrating another example of a stack structure of a pixel electrode, an optical auxiliary layer, an intermediate layer, a capping layer, and a color filter layer of FIG. 3;
FIG. 11 is a cross-sectional view schematically illustrating another example of a stack structure of a pixel electrode, an optical auxiliary layer, an intermediate layer, a capping layer, and a color filter layer of FIG. 3;
FIG. 12 is a cross-sectional view schematically illustrating another example of a stack structure of a pixel electrode, an optical auxiliary layer, an intermediate layer, a capping layer, and a color filter layer of FIG. 3; and
FIGS. 13 and 14 are cross-sectional views schematically illustrating examples of a cross-section corresponding to a stack structure of a pixel electrode, an optical auxiliary layer, an intermediate layer, a capping layer, and a color filter layer of FIG. 3, in a display apparatus according to a comparative example.

## DETAILED DESCRIPTION

Reference will now be made in more detail to aspects of some embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or variations thereof.

Because various modifications and various embodiments of the present disclosure are possible, specific embodiments are illustrated in the drawings and described in detail in the detailed description. Effects and features of the present disclosure, and a method of achieving them will be apparent with reference to embodiments described below in detail in conjunction with the drawings. However, the present disclosure is not limited to the embodiments disclosed herein, but may be implemented in a variety of forms.

Hereinafter, embodiments of the present disclosure will be described in detail with reference to the accompanying drawings, and the same or corresponding components are denoted by the same reference numerals, and the same reference numerals are assigned and redundant explanations will be omitted.

In the following embodiments, when a portion such as a layer, a film, a region, a plate or the like is on other portions, this is not only when the portion is on other elements, but also when other elements are interposed therebetween. In addition, in the drawings, for convenience of explanation, the sizes of elements may be exaggerated or reduced. For example, because the size and thickness of each component shown in the drawings are arbitrarily indicated for convenience of explanation, the present disclosure is not necessarily limited to the illustration.

In the following embodiments, the x-axis, the y-axis, and the z-axis are not limited to three axes on a Cartesian coordinate system, and may be interpreted in a broad sense including the same. For example, the x-axis, the y-axis, and the z-axis may be perpendicular to each other, but may refer to different directions that are not orthogonal to each other.

Hereinafter, a display apparatus according to some embodiments will be described based on the above description in detail as follows.

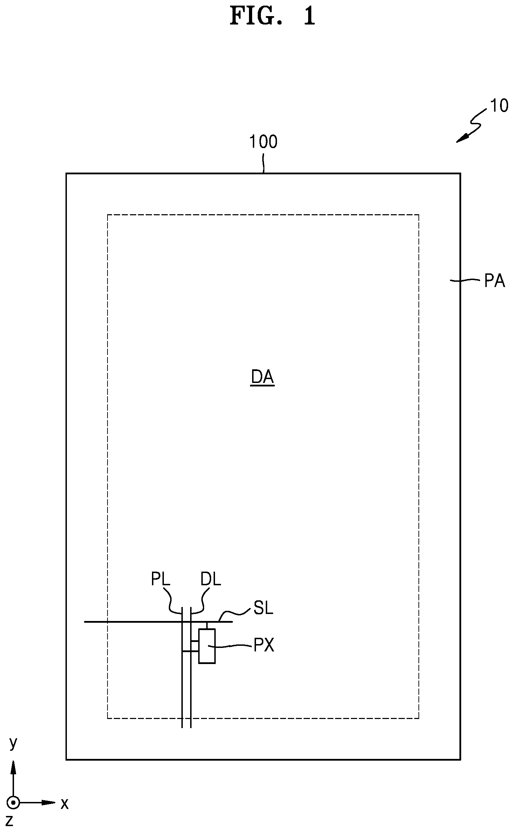

FIG. 1 is a plan view schematically illustrating a display panel of a display apparatus according to some embodiments.

As illustrated in FIG. 1, a display apparatus according to some embodiments may include a display panel 10. Such a display apparatus may be any one that includes the display panel 10. For example, a display apparatus may be a variety of apparatuses, such as smartphones, tablets, laptops, televisions, or billboards. Because a display apparatus according to some embodiments includes thin-film transistors and capacitors or the like, the thin-film transistors and the capacitors or the like may be implemented by conductive layers and insulating layers.

The display panel 10 may include a display area DA and a peripheral area PA outside (e.g., in a periphery or outside a footprint of) the display area DA. In FIG. 1, the display area DA is illustrated as having a rectangular shape. However, embodiments are not limited thereto. The display area DA may have various shapes such as a circular shape, an elliptical shape, a polygonal shape, a shape of a specific figure, and the like.

The display area DA is where images are displayed, and a plurality of pixels PX may be arranged in the display area DA. Each of the plurality of pixels PX may include a display element such as an organic light-emitting diode. Each pixel PX may emit red, green, or blue light, for example. A pixel PX may be connected to a pixel circuit including a thin-film transistor (TFT), a storage capacitor, and the like. The pixel circuit may be connected to a scan line SL configured to transmit a scan signal therethrough, a data line DL that crosses the scan line SL and is configured to transmit a data signal therethrough and a driving voltage line PL configured to supply a driving voltage therethrough. The scan line SL may extend in an x direction (hereinafter, a second direction), and the data line DL and the driving voltage line PL may extend in a y direction (hereinafter, a first direction).

The pixel PX may emit light with luminance corresponding to an electrical signal from the pixel circuit electrically connected to the pixel PX. In the display area DA, a certain image may be displayed through light emitted from the pixel PX. For reference, the pixel PX may be defined as a light-emitting area in which any one of red, green and blue light is emitted, as described above.

The peripheral area PA may be an area in which the pixel PX is not located and no images are displayed. A power supply wiring for driving the pixel PX may be located in the peripheral area PA. In addition, a plurality of pads may be arranged in the peripheral area PA, and a printed circuit board including a driving circuit unit or an integrated circuit device such as a driver integrated circuit (IC) may be arranged to be electrically connected to the plurality of pads.

For reference, because the display panel 10 includes a substrate 100, the substrate 100 may have the display area DA and the peripheral area PA. A detailed description of the substrate 100 will be described in more detail below.

In addition, a plurality of transistors may be arranged in the display area DA. In the plurality of transistors, according to the type of a transistor (N-type or P-type) and/or operation conditions, a first terminal of a transistor may be a source electrode or a drain electrode, and a second terminal of the transistor may be an electrode that is different from the first terminal. For example, when the first terminal is a source electrode, the second terminal may be a drain electrode.

The plurality of transistors may include a driving transistor, a data writing transistor, a compensation transistor, an initialization transistor, an emission control transistor, or the like. The driving transistor may be connected between the driving voltage line PL and the organic light-emitting diode OLED, and the data writing transistor may be connected to the data line DL and the driving transistor and may perform a switching operation for transmitting a data signal through the data line DL.

The compensation transistor may be turned on in response to the scan signal received through the scan line SL to connect the driving transistor to the organic light-emitting diode OLED, thereby compensating for a threshold voltage of the driving transistor.

The initialization transistor may be turned on in response to the scan signal received through the scan line SL to transmit an initialization voltage to a gate electrode of the driving transistor, thereby initializing the gate electrode of the driving transistor. The scan line connected to the initialization transistor may be a separate scan line that is different from the scan line connected to the compensation transistor.

The emission control transistor may be turned on in response to the emission control signal received through the emission control line, and as a result, a driving current may flow through the organic light-emitting diode OLED.

The organic light-emitting diode OLED may include a pixel electrode 150 (anode) and an opposite electrode 170 (cathode), and a second power supply voltage ELVSS may be applied to the opposite electrode 170. The organic light-emitting diode OLED may receive a driving current from the driving transistor to emit light, thereby displaying an image.

Hereinafter, an organic light-emitting display apparatus will be described as a display apparatus according to some embodiments, but the display apparatus of the present disclosure is not limited thereto. According to some embodiments, a display apparatus of the present disclosure may be a display apparatus such as an inorganic light-emitting display or inorganic electroluminescent (EL) display apparatus, or a quantum dot light-emitting display. For example, a light-emitting layer of a display element of the display apparatus may include an organic material or an inorganic material. In addition, the display apparatus may include a light-emitting layer, and quantum dots located on the path of light emitted from the light-emitting layer.

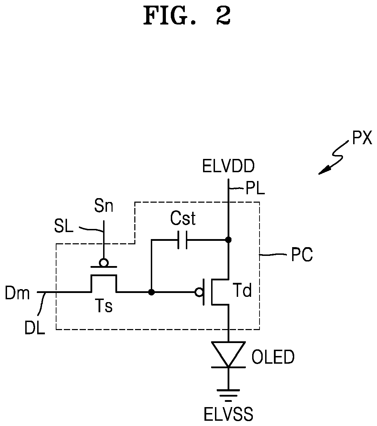

FIG. 2 is an equivalent circuit diagram of one pixel of the display panel 10 of FIG. 1.

Referring to FIG. 2, each pixel PX may include a pixel circuit PC connected to a scan line SL and a data line DL, and an organic light-emitting diode OLED connected to the pixel circuit PC.

The pixel circuit PC may include a driving thin-film transistor Td, a switching thin-film transistor Ts, and a storage capacitor Cst. The switching thin-film transistor Ts may be connected to the scan line SL and the data line DL and may transmit a data signal Dm input through the data line DL to the driving thin-film transistor Td in response to the scan signal Sn input through the scan line SL.

The storage capacitor Cst may be connected to the switching thin-film transistor Ts and the driving voltage line PL and may store a voltage corresponding to the difference between a voltage transmitted from the switching thin-film transistor Ts and a first power supply voltage ELVDD supplied to the driving voltage line PL.

The second power supply voltage ELVSS may be a driving voltage having a relatively lower level than the first power supply voltage ELVDD. The level of a driving voltage supplied to each pixel PX may be the difference between a level of the first power supply voltage ELVDD and a level of the second power supply voltage ELVSS.

The driving thin-film transistor Td may be connected to the driving voltage line PL and the storage capacitor Cst, and may control a driving current flowing through the organic light-emitting diode OLED from the driving voltage line PL in response to a voltage value stored in the storage capacitor Cst. The organic light-emitting diode OLED may emit light having certain luminance by using the driving current.

Although FIG. 2 illustrates the case where the pixel circuit PC includes two thin-film transistors and one storage capacitor, embodiments are not limited thereto. The pixel circuit PC may also include two or more storage capacitors. The pixel circuit PC is not limited to the components illustrated and described above, and according to some embodiments, the pixel circuit PC may include additional components or fewer components without departing from the scope of embodiments according to the present disclosure.

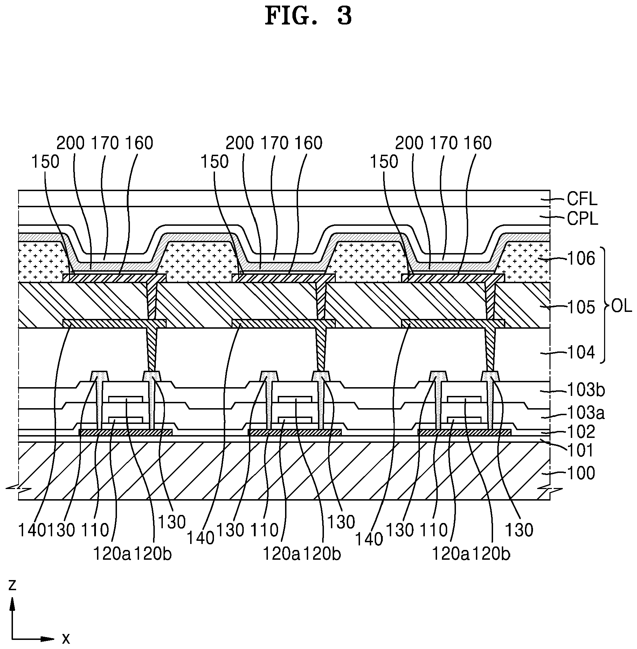

FIG. 3 is a cross-sectional view schematically a part of the display panel of FIG. 1.

The substrate 100 may include areas corresponding to a display area DA and a peripheral area PA outside the display area DA, as described above. The substrate 100 may include various flexible or bendable materials. For example, the substrate 100 may include glass, metal or polymer resin. In addition, the substrate 100 may include a polymer resin, such as polyethersulfone, polyacrylate, polyether imide, polyethylene naphthalate, polyethylene terephthalate, polyphenylene sulfide, polyarylate, polyimide, polycarbonate, or cellulose acetate propionate. Of course, various modifications are possible, such as the substrate 100 may have a multi-layered structure including two layers including such a polymeric resin and a barrier layer between the layers, wherein the barrier layer includes an inorganic material (e.g., silicon oxide, silicon nitride, silicon oxynitride, etc.) between the layers.

Alternatively, in order to implement ultra-high resolution, the substrate 100 may include a semiconductor material, for example, a IV-group semiconductor, a III-V-group compound semiconductor, or a II-VI-group compound semiconductor. The substrate 100 may include a silicon layer. That is, the substrate 100 may be a semiconductor substrate including a semiconductor material. The substrate 100 may be a substrate including a silicon wafer formed by using a semiconductor process. In this case, an active layer may be formed inside the substrate 100 including a silicon wafer, and a gate line, a data line, and a transistor may be arranged on an upper surface of the substrate 100. In this way, the organic light-emitting diode OLED that uses a substrate including a silicon wafer may be referred to as an OLED on Silicon (OLEDoS). For example, in the case of an OLEDoS, a compound metal oxide semiconductor (CMOS) process is required to form fine pixels, and an OLED device may be formed on an electrode formed by using the CMOS process. In the OLEDoS, in order to implement red (R), green (G), and blue (B) colors, respectively, generally, a white OLED may be made and a color filter may be located on the white OLED so that R, G, and B colors may be implemented. The OLEDoS may be used mainly for expansion reality (XR), and more than 8K high quality may be implemented in a small area of about 1 inch about 2 inches. When using a semiconductor substrate, dense control of pixels arranged in ultra-high resolution is possible. However, one or more embodiments are not limited thereto.

A buffer layer 101 may be located on the substrate 100. The buffer layer 101 may prevent or reduce impurity ions from being diffused, may prevent or reduce penetration of moisture or outside air, and may serve as a barrier layer and/or a blocking layer for planarizing the surface of the substrate 100. The buffer layer 101 may include silicon oxide, silicon nitride, or silicon oxynitride. In addition, the buffer layer 101 may regulate the rate of providing heat during the crystallization process to form a semiconductor layer 110 so that the semiconductor layer 110 may be uniformly crystallized.

The semiconductor layer 110 may be located on the buffer layer 101. The semiconductor layer 110 may include polysilicon and may include a channel region in which impurities are not doped, and a source region and a drain region, which are at both sides of the channel region and doped with impurities. Here, the impurities may vary according to the type of thin-film transistor and may be N-type impurities or P-type impurities.

A gate insulating layer 102 may be located on the semiconductor layer 110. The gate insulating layer 102 may be a component for securing an insulation property between the semiconductor layer 110 and a gate layer 120. The gate insulating layer 102 may include an inorganic material such as silicon oxide, silicon nitride, and/or silicon oxynitride and may be between the semiconductor layer 110 and the gate layer 120. In addition, the gate insulating layer 102 may have a shape corresponding to the entire surface of the substrate 100 and may have a structure in which contact holes are formed at a preset portion. Similarly, insulating layers including an inorganic material may be formed on/above the substrate 100 through chemical vapor deposition (CVD) or atomic layer deposition (ALD). This is also applied to the following embodiments and modifications thereof.

A first gate layer 120a may be located on the gate insulating layer 102. The first gate layer 120a may be located at a position in which the first gate layer 120a overlaps the semiconductor layer 110 vertically and may include at least one of the group consisting of molybdenum (Mo), aluminium (Al), platinum (Pt), palladium (Pd), silver (Ag), magnesium (Mg), gold (Au), nickel (Ni), neodymium (Nd), iridium (Ir), chromium (Cr), lithium (Li), calcium (Ca), titanium (Ti), tungsten (W), or copper (Cu).

A first interlayer insulating layer 103a may be located on the first gate layer 120a. The first interlayer insulating layer 103a may cover the first gate layer 120a. The first interlayer insulating layer 103a may include an inorganic material. For example, the first interlayer insulating layer 103a may be metal oxide or metal nitride, and specifically, the inorganic material may include silicon oxide ($SiO_2$), silicon nitride ($SiN_x$), silicon oxynitride (SiON), aluminium oxide ($Al_2O_3$), titanium oxide ($TiO_2$), tantalum oxide ($Ta_2O_5$), hafnium oxide ($HfO_2$), or zinc oxide ($ZrO_2$). The first interlayer insulating layer 103a may include a double structure of $SiO_x/SiN_y$ or $SiN_x/SiO_y$ in some embodiments.

A second gate insulating layer 120b may be located on the first interlayer insulating layer 103a. The second gate layer 120b may be located at a position in which the second gate layer 120b overlaps the first gate layer 120a vertically and may include at least one of the group consisting of Mo, Al, Pt, Pd, Ag, Mg, Au, Ni, Nd, Ir, Cr, Li, Ca, Ti, W, and Cu.

The second gate layer 120b may constitute the storage capacitor Cst described above in FIG. 2 with the first gate layer 120a. The first gate layer 120a may be one electrode of the storage capacitor Cst, and the second gate layer 120b may be the other electrode of the storage capacitor Cst.

A second interlayer insulating layer 103b may be located on the second gate layer 120b. The second interlayer insulating layer 103b may cover the second gate layer 120b. The second interlayer insulating layer 103b may include an inorganic material. For example, the second interlayer insulating layer 103b may be metal oxide or metal nitride, and specifically, the inorganic material may include silicon oxide ($SiO_2$), silicon nitride ($SiN_x$), silicon oxynitride (SiON), aluminium oxide ($Al_2O_3$), titanium oxide ($TiO_2$), tantalum oxide ($Ta_2O_5$), hafnium oxide ($HfO_2$), or zinc oxide ($ZrO_2$). The second interlayer insulating layer 103b may include a double structure of $SiO_x/SiN_y$ or $SiN_x/SiO_y$ in some embodiments.

A first conductive layer 130 may be located on the second interlayer insulating layer 103b. The first conductive layer 130 may serve as an electrode connected to a source/drain region of a semiconductor layer through a through hole in the second interlayer insulating layer 103b. The first conductive layer 130 may include at least one metal selected from the group consisting of Al, Pt, Pd, Ag, Mg, Au, Ni, Nd, Ir, Cr, Li, Ca, Mo, Ti, W, and Cu. For example, the first conductive layer 130 may include a Ti layer, an Al layer, and/or a Cu layer.

A first organic insulating layer 104 may be located on the first conductive layer 130. The first organic insulating layer 104 may be an organic insulating layer that covers the top of the first conductive layer 130 and has a substantially flat top surface and serves as a planarization layer. The first organic insulating layer 104 may include an organic material such as acryl, benzocyclobutene (BCB) or hexamethyldisiloxane (HMDSO). The first organic insulating layer 104 may be variously modified such as having a single layer or multi-layered structure.

A second conductive layer 140 may be located on the first organic insulating layer 104. The second conductive layer 140 may serve as an electrode connected to a source/drain region of a semiconductor layer through a through hole in the first organic insulating layer 104. The second conductive layer 140 may include at least one metal selected from the group consisting of Al, Pt, Pd, Ag, Mg, Au, Ni, Nd, Ir, Cr, Li, Ca, Mo, Ti, W, and/or Cu. For example, the second conductive layer 140 may include a Ti layer, an Al layer, and/or a Cu layer.

A second organic insulating layer 105 may be located on the first conductive layer 130. The second organic insulating layer 105 may be an organic insulating layer that covers the top of the first conductive layer 130 and has a substantially flat top surface and serves as a planarization layer. The second organic insulating layer 105 may include an organic material such as acryl, BCB, or HMDSO. The second organic insulating layer 105 may be variously modified such as having a single layer or multi-layered structure.

In addition, according to some embodiments, an additional conductive layer and an additional insulating layer may be between the conductive layer and a pixel electrode 150 and may be applied to various embodiments. In this case, the additional conductive layer may include the same material as the above-described conductive layer and may have the same layer structure. The additional conductive layer may include the same material as the above-described organic insulating layer and may have the same layer structure.

The pixel electrode 150 may be located on the second organic insulating layer 105. The pixel electrode 150 may be connected to the second conductive layer 140 through a contact hole formed in the second organic insulating layer 105. A display element may be located on the pixel electrode 150. The organic light-emitting diode OLED may be used as the display element. That is, the organic light-emitting diode OLED may be located on the pixel electrode 150, for example. The pixel electrode 150 may include a transparent conductive layer formed of transparent conductive oxide such as ITO, $In_2O_3$, or IZO, and a reflective layer formed of metal such as Al or Ag. For example, the pixel electrode 150 may have a three-layer structure of ITO/Ag/ITO.

A pixel-defining layer 106 may be located on the second organic insulating layer 105 and may be arranged to cover edges of the pixel electrode 150. That is, the pixel-defining layer 106 may cover edges of the pixel electrode 150. The pixel-defining layer 106 may have an opening corresponding to the pixel PX, and the opening may be formed so that at least a center portion of the pixel electrode 150 may be exposed. The pixel-defining layer 106 may include an organic material such as polyimide or HMDSO, or an inorganic material such as a silicon compound (e.g., $SiN_x$, $SiO_x$, etc.).

In addition, a spacer may be located on the pixel-defining layer 106. The spacer may be located in the peripheral area PA but may also be located in the display area DA. The spacer may prevent or reduce instances of the organic light-emitting diode OLED being damaged by sagging of a mask in a manufacturing process using the mask. The spacer may include an organic insulating material and may have a single layer or multi-layered structure.

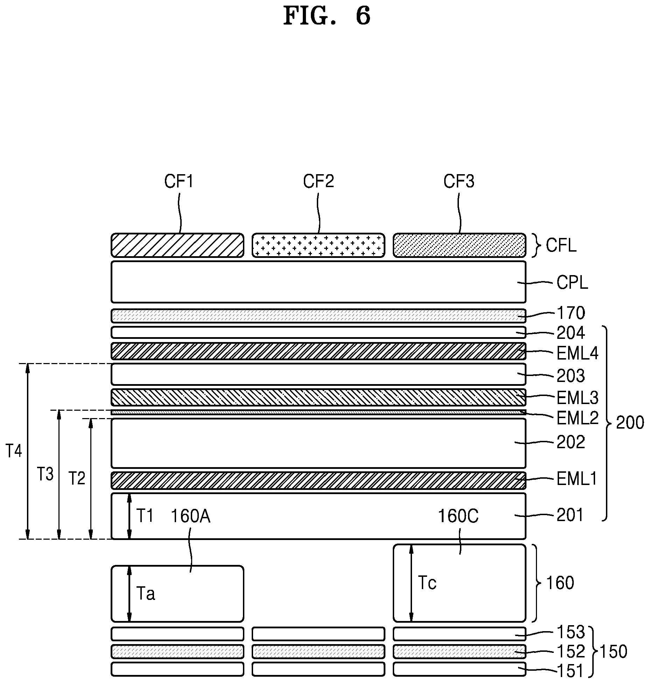

An optical auxiliary layer 160 may be located on the pixel electrode 150. For example, the optical auxiliary layer 160 may be located on the opening of the pixel-defining layer 106. The optical auxiliary layer 160 may be or include an inorganic material layer including $SiN_x$ and/or $SiO_x$. As described later with respect to FIG. 6, the optical auxiliary layer 160 may include a plurality of optical auxiliary bodies arranged side-by-side in a direction parallel to the substrate 100. Each of the plurality of optical auxiliary bodies may be an inorganic structure for optical resonance, and a description thereof will be provided later.

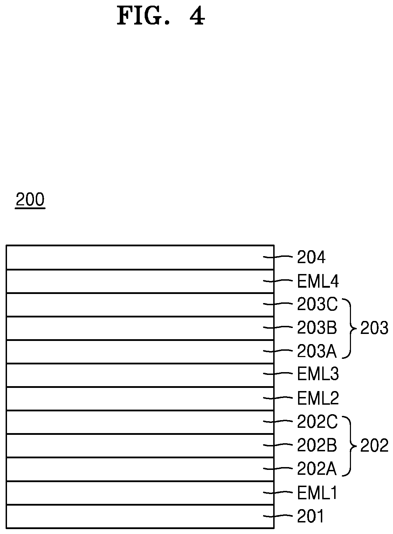

An intermediate layer 200 and an opposite electrode 170 may be located on the opening of the pixel-defining layer 106. The intermediate layer 200 may include a low molecular weight material or polymer material, and the intermediate layer 200 may include a hole injection layer, a hole transport layer, an emission layer, an electron transport layer and/or an electron injection layer. A detailed description of the intermediate layer 200 will be provided later in detail with reference to FIG. 4.

The opposite electrode 170 may include a transparent conductive layer formed of a transparent conductive oxide such as ITO, $In_2O_3$, or IZO. Alternatively, the opposite electrode 170 may be a conductive layer including Ag and/or Mg. The pixel electrode 150 may be used as an anode, and the opposite electrode 170 may be used as a cathode. Of course, the polarity of electrodes may be reversed.

The structure of the intermediate layer 200 is not limited to the above description, and may have various structures. For example, at least one of layers forming the intermediate layer 200 may be integrally formed, as the opposite electrode 170. According to some embodiments, the intermediate layer 200 may include a layer patterned to correspond to each of the plurality of pixel electrodes 150.

The opposite electrode 170 may be located on top of the display area DA and may be located in front of the display area DA. That is, the opposite electrode 170 may be integrally formed to cover a plurality of pixels. The opposite electrode 170 may be in electrical contact with a common power supply line located in the peripheral area PA. According to some embodiments, the opposite electrode 170 may extend to a barrier wall.

A capping layer CPL may be formed on the opposite electrode 170 by stacking at least an organic capping layer and an inorganic capping layer. The capping layer CPL may be formed by thermal evaporation deposition or e-beam evaporation deposition. Forming of the capping layer CPL may include performing of a deposition process at a relatively higher temperature than a deposition process of forming a light-emitting layer included in the intermediate layer 200. Alternatively, the capping layer CPL may be formed in a multi-layered structure in which dielectric thin films having different indexes of refraction are alternately and repeatedly stacked.

A color filter layer CFL may be located on the capping layer CPL. The color filter layer CFL that is a component through which light in a particular wavelength band transmits may be a component through which light in a wavelength band of R, G and B colors corresponding to each pixel transmits. The color filter layer CFL may include a first color filter, a second color filter, and a third color filter, and a description of each color filter will be provided later.

According to some embodiments, a light-shielding layer for blocking emission of light generated by the intermediate layer 200 may be located between the color filter layers. The light-shielding layer may be a black matrix and may include various materials that absorb at least a part of light. For example, the light-shielding layer may include at least one of carbon black, graphite, chrome-based materials, dyes, a metal reflective layer, or a light-absorbing layer. The light-shielding layer may block or prevent or reduce reflection of external light and may prevent or reduce internal reflection of light generated by the display element.

According to some embodiments, a thin-film encapsulation layer may be located on the opposite electrode 170. In some cases, the thin-film encapsulation layer may be located between the opposite electrode 170 and the capping layer CPL, or may be located on the capping layer CPL. A thin-film encapsulation layer may entirely cover the display area DA, may extend to the peripheral area PA, and may be arranged to cover at least a part of the peripheral area PA.

The thin-film encapsulation layer may include a first inorganic encapsulation layer, a second inorganic encapsulation layer, and an organic encapsulation layer therebetween. The first inorganic encapsulation layer and the second inorganic encapsulation layer may each include an inorganic material including at least one of aluminium oxide, titanium oxide, tantalum oxide, hafnium oxide, zinc oxide, silicon oxide, silicon nitride, or silicon oxynitride.

The organic encapsulation layer may include a monomer-based material or a polymer-based material. The polymer-based material may include an acryl-based resin, an epoxy-based resin, polyimide, polyethylene, or the like. According to some embodiments, the organic encapsulation layer may include acrylate.

A barrier wall may be located in the peripheral area PA of the substrate 100. According to some embodiments, the barrier wall may include a portion of the first organic insulating layer 104, a portion of the second organic insulating layer 105, a portion of the pixel-defining layer 106, and a portion of a spacer. However, embodiments are not limited thereto.

As occasion demands, the barrier wall may be arranged to surround the display area DA and may prevent or reduce instances of the material of the organic encapsulation layer of the thin-film encapsulation layer overflowing to the outside of the substrate 100.

FIG. 4 is a conceptual diagram schematically illustrating a cross-section of an intermediate layer of FIG. 3. For your reference, the same or redundant descriptions as those given with reference to FIG. 4 may be omitted.

As shown in FIG. 4, the intermediate layer 200 includes a first emission layer EML1, a second emission layer EML2, a third emission layer EML3, and a fourth emission layer EML4. The first through fourth emission layers EML1, EML2, EML3, and EML4 may be vertically-stacked layers, and the first emission layer EML1 and the fourth emission layer EML4 emit light in the same wavelength band.

In an example, the first emission layer EML1 and the fourth emission layer EML4 may emit blue-based visible light, the second emission layer EML2 may emit red-based visible light, and the third emission layer EML3 may emit green-based visible light.

In an example, the first through fourth emission layers EML1, EML2, EML3, and EML4 may overlap each other in a plan view. In this case, the first emission layer EML1 and the second emission layer EML2 may be spaced apart from each other in a thickness direction of the first emission layer EM1, and the third emission layer EML3 and the fourth emission layer EML4 may be spaced apart from each other in the thickness direction of the first emission layer EML1. The second emission layer EML2 and the third emission layer EML3 may be located adjacent to each other.

The intermediate layer 200 may further include a first hole transport layer 201. The first hole transport layer 201 may be located on the pixel electrode 150. The first hole transport layer 201 may be configured to transmit an electron hole from the organic light-emitting diode OLED and may be an organic material layer into which the electron hole may be injected from the pixel electrode 150. For convenience of explanation, it may be understood that, in the present specification, the first hole transport layer 201 includes an electron injection layer.

The intermediate layer 200 include the first emission layer EML1 that emits light in a first wavelength band. The first emission layer EML1 may be located on the first hole transport layer 201. The thickness of the first emission layer EML1 may be about 140 Å to about 240 Å, preferably, 190 Å. The first emission layer EML1 may be an organic material layer that emits blue-based visible light.

The intermediate layer 200 includes the second emission layer EML2 that emits light in a second wavelength band. The second emission layer EML2 may be located on the first emission layer EML1. The thickness of the second emission layer EML2 may be about 30 Å to about 70 Å, preferably, 50 Å. The second emission layer EML2 may be an organic material layer that emits red-based visible light.

The intermediate layer 200 includes the third emission layer EML3 that emits light in a third wavelength band. The third emission layer EML3 may be located on the second emission layer EML2. The thickness of the third emission layer EML3 may be about 250 Å to about 450 Å, preferably, 350 Å. The third emission layer EML3 may be an organic material layer that emits green-based visible light.

The intermediate layer 200 includes the fourth emission layer EML4 that emits light in the first wavelength band. The fourth emission layer EML4 may be located on the third emission layer EML3. The thickness of the fourth emission layer EML4 may be about 140 Å to about 240 Å, preferably, 190 Å. The fourth emission layer EML4 may be an organic material layer that emits blue-based visible light.

The intermediate layer 200 may further include a first connection layer 202 between the first emission layer EML1 and the second emission layer EML2. The first connection layer 202 may be an organic material layer including a first electron transport layer 202A, a first charge generation layer 202B, and a second hole transport layer 202C. The thickness of the first connection layer 202 may be about 450 Å to about 750 Å, preferably, 610 Å.

As a result of numerical limitations to the thickness of the first connection layer 202, the display apparatus according to some embodiments may implement a more efficient resonance structure compared to display apparatuses according to comparative examples to be described later. As a result, a display apparatus having high light efficiency may be provided.

The first electron transport layer 202A may be located on the first emission layer EML1. A lower surface of the first electron transport layer 202A may be in contact with an upper surface of the first emission layer EML1. The first electron transport layer 202A may be configured to transmit electrons from the organic light-emitting diode OLED and may be an organic material layer. For convenience of explanation, it may be understood that, in the present specification, the first electron transport layer 202A includes an electron injection layer.

The first charge generation layer 202B may be located on the first electron transport layer 202A. A lower surface of the first charge generation layer 202B may be in contact with an upper surface of the first electron transport layer 202A. The first charge generation layer 202B may include a P-type charge generation layer and an N-type charge generation layer. The P-type charge generation layer may include a host material having a hole transport capability, and the N-type charge generation layer may include a host material having an electron transport capability. For example, the N-type charge generation layer may be configured to inject electrons into the first emission layer EML1, and the P-type charge generation layer may be configured to inject holes into the second emission layer EML2.

The second hole transport layer 202C may be located on the first charge generation layer 202B. A lower surface of the second hole transport layer 202C may be in contact with an upper surface of the first charge generation layer 202B. The second hole transport layer 202C may be configured to transmit an electron hole from the organic light-emitting diode OLED and may be an organic material layer. For convenience of explanation, it may be understood that, in the present specification, the second hole transport layer 202C includes an HIL(for example, p-doped HTL)"

As shown in FIG. 4, the intermediate layer 200 may further include a second connection layer 203 between the third emission layer EML3 and the fourth emission layer EML4. The second connection layer 203 may be an organic material layer including a second electron transport layer 203A, a second charge generation layer 203B, and a third hole transport layer 203C. The thickness of the second connection layer 203 may be about 210 Å to about 310 Å, preferably, 265 Å.

As a result of numerical limitations to the thickness of the second connection layer 203, the display apparatus according to some embodiments may implement a more efficient resonance structure compared to display apparatuses according to comparative examples to be described later. As a result, a display apparatus having high light efficiency may be provided.

The second electron transport layer 203A may be located on the third emission layer EML3. A lower surface of the second electron transport layer 203A may be in contact with an upper surface of the third emission layer EML3. The second electron transport layer 203A may be configured to transmit electrons from the organic light-emitting diode OLED and may be an organic material layer. For convenience of explanation, it may be understood that, in the present specification, the second electron transport layer 203A includes an electron injection layer.

The second charge generation layer 203B may be located on the second electron transport layer 203A. A lower surface of the second charge generation layer 203B may be in contact with an upper surface of the second electron transport layer 203A. The second charge generation layer 203B may include a P-type charge generation layer and an N-type charge generation layer. The P-type charge generation layer may include a host material having a hole transport capability, and the N-type charge generation layer may include a host material having an electron transport capability. For example, the N-type charge generation layer may be configured to inject electrons into the third emission layer EML3, and the P-type charge generation layer may be configured to inject holes into the fourth emission layer EML4.

The third hole transport layer 203C may be located on the second charge generation layer 203B. A lower surface of the third hole transport layer 203C may be in contact with an upper surface of the second charge generation layer 203B. The third hole transport layer 203C may be configured to transmit an electron hole from the organic light-emitting diode OLED and may be an organic material layer. For convenience of explanation, it may be understood that, in the present specification, the third hole transport layer 203C includes an HIL.

As shown in FIG. 4, the intermediate layer 200 may further include a third electron transport layer 204 located on the fourth emission layer EML4. The third electron transport layer 204 may be located on the fourth emission layer EML4. A lower surface of the third electron transport layer 204 may be in contact with an upper surface of the fourth emission layer EML4. The third electron transport layer 204 may be configured to transmit electrons from the organic light-emitting diode OLED and may be an organic material layer. For convenience of explanation, it may be understood that, in the present specification, the third electron transport layer 204 includes an electron injection layer. The opposite electrode 170 described above may be located on the third electron transport layer 204.

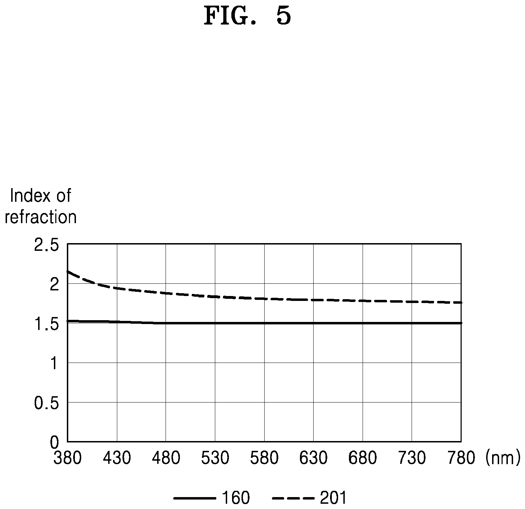

FIG. 5 is a graph illustrating an index of refraction of an optical auxiliary layer of FIG. 3 and an index of refraction of a first hole transport layer of FIG. 4.

For your reference, the same or redundant descriptions as those given with reference to FIG. 5 may be omitted. However, the horizontal axis of FIG. 5 represents a wavelength of light and the vertical axis of FIG. 5 represents an index of refraction.

As shown in FIG. 5, the optical auxiliary layer 160 that is an inorganic material layer including $SiN_x$ and/or $SiO_x$ may have an index of refraction of about 1.5, and changes in indexes of refraction according to the wavelength of light transmitting through the optical auxiliary layer 160 are rarely observed. However, the first hole transport layer 201 that is the organic material layer may have an index of refraction that increases as the wavelength decreases, and the index of refraction of the first hole transport layer 201 may be in a range of about 1.6 to about 2.2.

Thus, because an optical path passing through the first hole transport layer 201 changes depending on the wavelength, the optical thickness of the first hole transport layer 201 may vary depending on the transmitting light or wavelength. However, because it may be difficult to vary the thickness of the first hole transport layer 201 according to wavelength, the thickness of each of the optical auxiliary bodies included in the optical auxiliary layer 160 may be adjusted so that the total length (i.e., the length of a path reflecting the index of refraction) of the optical path through which the wavelength passes may be adjusted.

FIG. 6 is a cross-sectional view schematically illustrating an example of a stack structure of a pixel electrode, an optical auxiliary layer, an intermediate layer, a capping layer, and a color filter layer of FIG. 3.

For reference, the same descriptions as in the description of FIG. 6 may be omitted, and for convenience of explanation, illustration of a structure such as a pixel-defining layer or the like may be omitted.

In addition, as a reference, although each of layers shown in FIG. 6 is shown to be spaced apart from another, this is only for the convenience of understanding and the exact illustration of each layer and the layers shown in FIG. 6 may not be spaced apart from each other. The layers may be in contact with each other, and as occasion demands, a different layer may be inserted between the layers. This is also applied to the other drawings in addition to FIG. 6.

As shown in FIG. 6, an example of the stack structure of FIG. 3 may include a pixel electrode 150, an optical auxiliary layer 160, an intermediate layer 200, an opposite electrode 170, a capping layer CPL, and a color filter layer CFL. For convenience of explanation, it will be described that components under the pixel electrode 150 include a substrate 100 and a circuit layer.

For example, the circuit layer may be located on the substrate 100 and may include at least one thin-film transistor. For example, the circuit layer may include at least one of a semiconductor layer 110, a gate insulating layer 102, a first gate layer 120a, a first interlayer insulating layer 103a, a first conductive layer 130, or a first organic insulating layer 104.

In some cases, the circuit layer may be interpreted as a concept including the semiconductor layer 110, the second conductive layer 140, and the second organic insulating layer 105 that covers the second conductive layer 140. However, the scope of the rights of the present disclosure is not limited thereto. For example, the circuit layer may refer to a plurality of layer structures arranged between the substrate 100 and the pixel electrode 150.

The pixel electrode 150 may include a reflective layer 152. The reflective layer 152 may include a metal material, such as Ag, Al, or the like. The reflective layer 152 may be a component for reflecting portions of light emitted from the intermediate layer 200 toward the color filter layer CFL. The thickness of the reflective layer 152 may be about 700 Å to about 1000 Å, and preferably, 850 Å.

The pixel electrode 150 may further include a first transparent electrode layer 153 located on the reflective layer 152. The first transparent electrode layer 153 may include a transparent conductive material such as ITO or the like. The thickness of the first transparent electrode 153 may be less than the thickness of the reflective layer 152. The thickness of the first transparent electrode 153 may be about 40 Å to about 100 Å, and preferably, 70 Å.

The pixel electrode 150 may further include a second transparent electrode layer 151 located under the reflective layer 152. Thus, the reflective layer 152 may be between the first transparent electrode layer 153 and the second transparent electrode layer 151. The second transparent electrode layer 151 may include a transparent conductive material such as ITO or the like. The thickness of the second transparent electrode layer 151 may be less than the thickness of the reflective layer 152. The thickness of the second transparent electrode 151 may be about 40 Å to about 100 Å, and preferably, 70 Å. An upper surface of the second transparent conductive layer 151 and a lower surface of the reflective layer 152 may be in contact with each other. As shown in FIG. 6, the optical auxiliary layer 160 includes a first optical auxiliary body 160A having a first thickness Ta and a second optical auxiliary body 160C having a second thickness Tc. The second thickness Tc is greater than the first thickness Ta, and the first optical auxiliary body 160A and the second optical auxiliary body 160C are arranged side-by-side. The optical auxiliary layer 160 may include $SiN_x$ and/or $SiO_x$, as described above, and may be or include an inorganic material layer. The optical auxiliary layer 160 may be between the first transparent conductive layer 153 and the intermediate layer 200.

As a result of numerical limitations to the thickness, the display apparatus according to some embodiments may implement a more efficient resonance structure compared to display apparatuses according to comparative examples to be described later. As a result, a display apparatus having high light efficiency may be provided.

As shown in FIG. 6, the pixel electrode 150 including the first transparent electrode layer 153, the second transparent electrode layer 151, and the reflective layer 152 may have a structure divided according to a pixel PX. In addition, one pixel PX may correspond to one of a first color filter CF1, a second color filter CF2, and a third color filter CF3 to be described later. In addition, the optical auxiliary layer 160 may include an optical auxiliary body corresponding to one pixel PX.

For example, the first optical auxiliary body 160A may correspond to one pixel PX and may correspond to the first color filter CF1. For example, the first optical auxiliary body 160A overlaps the first color filter CF1 in a plan view.

For example, the second optical auxiliary body 160C may correspond to another pixel and may correspond to the third color filter CF3. For example, the second optical auxiliary body 160C overlaps the third color filter CF3 in a plan view.

An intermediate layer 200 is located on the optical auxiliary layer 160. The intermediate layer 200 may include a first hole transport layer 201, a first emission layer EML1, a first connection layer 202, a second emission layer EML2, a third emission layer EML3, a second connection layer 203, a fourth emission layer EML4, and a third electron transport layer 204.

For example, the first connection layer 202 may be located between the first emission layer EML1 and the second emission layer EML2, and the second connection layer 203 may be located between the third emission layer EML3 and the fourth emission layer EML4. The thickness of the first connection layer 202 and the thickness of the second connection layer 203 may be greater than the thickness of the first emission layer EML1.

For example, the sum of the optical thickness of the first hole transport layer 201 in the first wavelength band and the optical thickness of the second optical auxiliary body 160C in the first wavelength band may coincide with the sum of the optical thickness of the first hole transport layer 201 in the second wavelength band and the optical thickness of the first optical auxiliary body 160A in the second wavelength band. In this case, the coincidence of the sum of the thicknesses may refer to coincidence within an error range that may occur in the measurement or micro process.

An optical thickness may mean a value obtained by multiplying the thickness of a certain layer by the index of refraction of the certain layer. The optical thickness of the first hole transport layer 201 in the first wavelength band may be a value obtained by multiplying the thickness of the first hole transport layer 201 by the index of refraction of the first hole transport layer 201 at about 460 nm (an example of a representative value in the first wavelength band). Similarly, the optical thickness of the second optical auxiliary body 160C in the first wavelength band may be a value obtained by multiplying the thickness of the second optical auxiliary body 160C by the index of refraction of the second optical auxiliary body 160C at about 460 nm (an example of a representative value in the first wavelength band).

For example, the optical thickness of the first electron transparent layer 201 in the first wavelength band may be in inverse proportion to the optical thickness of the second optical auxiliary body 160C in the first wavelength band. Because the sum of the optical thickness of the first hole transport layer 201 in the first wavelength band and the optical thickness of the second optical auxiliary body 160C in the first wavelength band has to be constant, the optical thickness of the second optical auxiliary body 160C in the first wavelength band needs to be increased by a reduction amount in the optical thickness of the first hole transport layer 201 in the first wavelength band. Thus, the inverse proportion relationship may be expressed as below.

Equation 1

$$\text{Reduction amount of } T1 \times n_{201} = \text{Increment of } Tc \times n_{160}$$

However, $n_{201}$ is an index of refraction of the first hole transport layer 201 in the first wavelength band, $n_{160}$ is an index of refraction of the second optical auxiliary body 160C in the first wavelength band, T1 is a thickness of the first hole transport layer 201, and Tc is a thickness of the second optical auxiliary body 160C.

Thus, according to the above equation, a part of the first hole transport layer 201 in the first wavelength band may be replaced with a part of the second optical auxiliary body 160C in the first wavelength band. In this case, the optical thickness of a part of the first hole transport layer 201 in the first wavelength band may coincide with the optical thickness of a part of the second optical auxiliary body 160C in the first wavelength band.

As a result of numerical limitations to the thickness, the display apparatus according to some embodiments may implement a more efficient resonance structure compared to display apparatuses according to comparative examples to be described later. As a result, a display apparatus having high light efficiency may be provided.

For example, the first emission layer EML1 may be an organic material layer that emits light in the first wavelength band. The thickness of the first emission layer EML1 may be less than a difference between the second thickness of the second optical auxiliary body 160C and the first thickness of the first optical auxiliary body 160A. The difference between the second thickness of the second optical auxiliary body 160C and the first thickness of the first optical auxiliary body 160A may be greater than the thickness of the first emission layer EML1. For example, the fourth emission layer EML4 may be an organic material layer that emits light in the first wavelength band, as shown in the first emission layer EML1, and the thickness of the fourth emission layer EML4 may coincide with the thickness of the first emission layer EML1.

For example, the first wavelength band may be a blue-based visible light region, the second wavelength band may be a red-based visible light region, and the third wavelength band may be a green-based visible light region.

As shown in FIG. 6, an opposite electrode 170 may be located on the third electron transport layer 204, a capping layer CPL may be located on the opposite electrode 170, and a color filter layer CFL may be located on the capping layer CPL. The color filter layer CFL includes a first color filter CF1 through which light in the second wavelength band transmits, a second color filter CF2 located side-by-side with the first color filter CF1 and through which light in a third wavelength band transmits, and a third color filter CF3 located side-by-side with the second color filter CF2 and through which light in the first wavelength band transmits. That is, light in the first wavelength band may transmit through the third color filter CF3, light in the second wavelength band may transmit through the first color filter CF1, and light in the third wavelength band may transmit through the second color filter CF2.

In this case, the first optical auxiliary body 160A and the first color filter CF1 overlap each other in a plan view, and the second optical auxiliary body 160C and the third color filter CF3 overlap each other in a plan view.

An example including detailed numerical values is as below.

For example, a difference between the first thickness Ta of the first optical auxiliary body 160A and a second thickness of the second optical auxiliary body 160C may be about 120 Å to about 180Å, preferably, 160 Å.

For example, the thickness of the intermediate layer 200 may be about 2200 Å to about 2800 Å, preferably, 2500 Å.

In FIG. 6, the third optical auxiliary body 160B having a third thickness Tb is not shown, and the third thickness Tb may mean 0. In this case, a difference between the third thickness Tb and the first thickness Ta may be about 900 Å to about 1020 Å, preferably, 960 Å. The difference between the first thickness Ta and the third thickness Tb is the same as the first thickness Ta, because the third thickness Tb is 0.

For example, the thickness of the first hole transport layer 201 may be greater than the thickness of the first connection layer 202. In addition, the thickness of the first connection layer 202 may be greater than the thickness of the second connection layer 203. The thickness of the first emission layer EML1 and the thickness of the fourth emission layer EML4 may coincide with each other. The thickness of the second emission layer EML2 may be less than the thickness of the third emission layer EML3. The thickness of the third emission layer EML3 may be greater than the thickness of the fourth emission layer EML4.

As a result of numerical limitations to the thickness, the display apparatus according to some embodiments may implement a more efficient resonance structure compared to display apparatuses according to comparative examples to be described later. As a result, a display apparatus having high light efficiency may be provided.

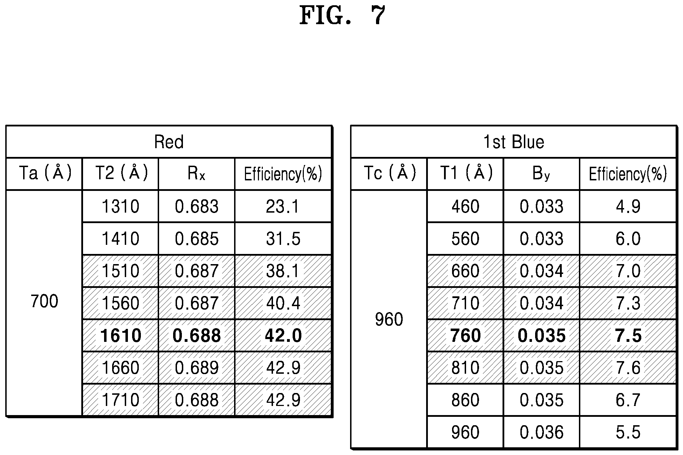

FIGS. 7 through 9 are tables showing light efficiency according to each wavelength band in the example of FIG. 6.

As shown in FIG. 7, the light efficiency of red-based visible light in the first wavelength band may be relatively higher when the first thickness Ta of the first optical auxiliary body 160A is about 700 Å and a distance between the second emission layer EML2 and the optical auxiliary layer (i.e., a distance between a lower surface of the second emission layer EML2 and a lower surface of the first hole transport layer 201) is about 1510 Å to about 1710 Å. According to some embodiments, when the first thickness Ta is about 700 Å and the distance between the second emission layer EML2 and the optical auxiliary layer is about 1610 Å, the light efficiency of the red-based visible light may be relatively higher.

As shown in FIG. 7, the light efficiency of blue-based visible light in the third wavelength band may be relatively higher when the second thickness of the second optical auxiliary body 160C is about 960 Å and a distance between the first emission layer EML1 and the optical auxiliary layer (i.e., a distance between a lower surface of the first emission layer EML1 and a lower surface of the first hole transport layer 201) is about 660 Å to about 810 Å. According to some embodiments, when the second thickness is about 960 Å and the distance between the first emission layer EML1 and the optical auxiliary layer is about 760 Å, the light efficiency of the blue-based visible light may be relatively higher.

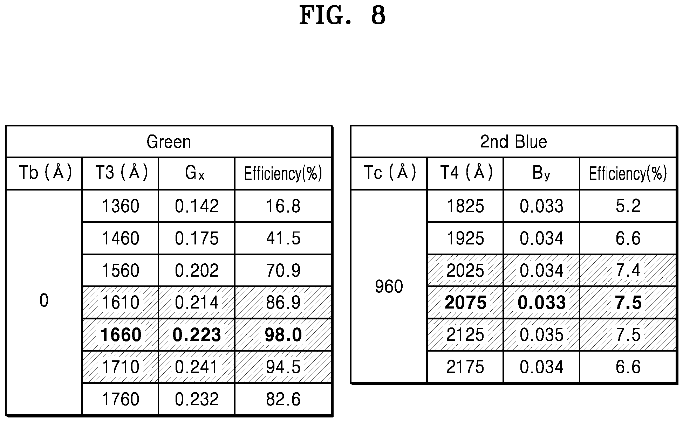

As shown in FIG. 8, the light efficiency of green-based visible light in the second wavelength band may be relatively higher when the third thickness Tb of the third optical auxiliary body 160B is about 0 Å and a distance between the third emission layer EML3 and the optical auxiliary layer (i.e., a distance between a lower surface of the third emission layer EML3 and a lower surface of the first hole transport layer 201) is about 1610 Å to about 1710 Å. According to some embodiments, when the third thickness Tb is about 0 Å and the distance between the third emission layer EML3 and the optical auxiliary layer is about 1660 Å, the light efficiency of the green-based visible light may be relatively higher.

As shown in FIG. 8, the light efficiency of blue-based visible light in the third wavelength band is relatively higher when the second thickness of the second optical auxiliary body 160C is about 960 Å and a distance between the fourth emission layer EML4 and the optical auxiliary layer (i.e., a distance between a lower surface of the fourth emission layer EML4 and a lower surface of the first hole transport layer 201) is about 2025 Å to about 2125 Å. According to some embodiments, when the second thickness is about 960 Å and the distance between the fourth emission layer EML4 and the optical auxiliary layer is about 2075 Å, the light efficiency of the blue-based visible light may be relatively higher.

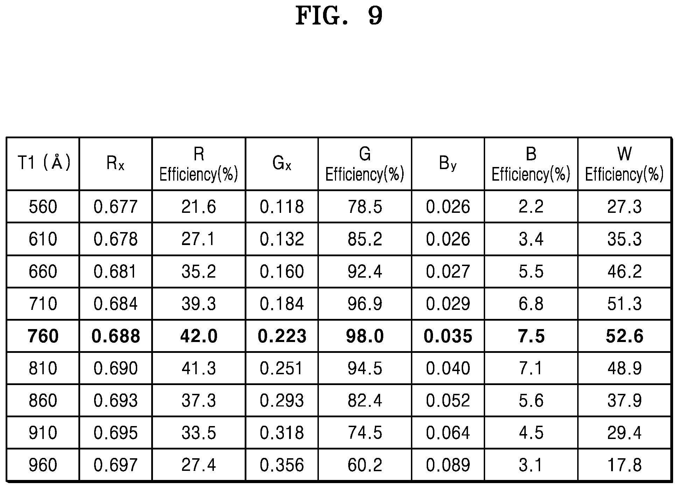

As shown in FIG. 9, in an example of FIG. 6, when the following conditions are satisfied, the light efficiency of white-based visible light may be highest.

(1) A distance between the first emission layer EML1 and the optical auxiliary layer is about 760 Å.
(2) A distance between the second emission layer EML2 and the optical auxiliary layer is about 1610 Å.
(3) A distance between the third emission layer EML3 and the optical auxiliary layer is about 1660 Å.
(4) A distance between the fourth emission layer EML4 and the optical auxiliary layer is about 2075 Å.
(5) The first thickness Ta is about 700 Å.
(6) The second thickness is about 960 Å.
(7) The third thickness Tb is about 0 Å.

As a result of numerical limitations to the thickness, the display apparatus according to some embodiments may implement a more efficient resonance structure compared to display apparatuses according to comparative examples to be described later. As a result, a display apparatus having high light efficiency may be provided.

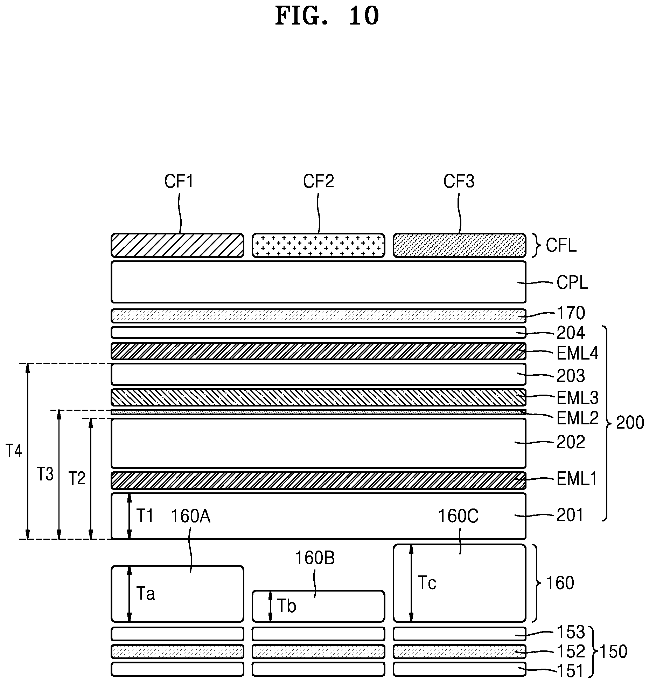

FIG. 10 is a cross-sectional view schematically illustrating another example of a stack structure of a pixel electrode, an optical auxiliary layer, an intermediate layer, a capping layer, and a color filter layer of FIG. 3. As a reference, the same or redundant descriptions as those given with reference to FIG. 10 may be omitted.

As shown in FIG. 10, the optical auxiliary layer may further include a third optical auxiliary body 160B that has the third thickness Tb and is located side-by-side with the above-described first optical auxiliary body 160A and the above-described second optical auxiliary body 160C. In this case, the third thickness Tb may be less than the first thickness Ta and the second thickness.

For example, a difference between the third thickness Tb and the second thickness Tc may be about 900 Å to about 1020 Å. For example, a difference between the second thickness Ta and the third thickness Tb may be six times the difference between the first thickness Ta and the second thickness Tc. For example, in a plan view, the third optical auxiliary body 160B may overlap the second color filter CF2.

As shown in FIG. 10, the thickness of the first hole transport layer 201 may be less than the thickness of the first connection layer 202. In addition, the thickness of the first hole transport layer 201 may be greater than the thickness of the second connection layer 203.

An example including detailed numerical values is as below.

For example, a difference between the first thickness Ta of the first optical auxiliary body 160A and a second thickness Tc of the second optical auxiliary body 160C may be about 120 Å to about 180 Å, preferably, 160 Å. A difference between the second thickness Tc of the second optical auxiliary body 160C and the third thickness Tb of the third optical auxiliary body 160B may be about 900 Å to about 1020 Å, preferably, 960 Å. For example, the thickness of the intermediate layer 200 may be about 2200 Å to about 2800 Å, preferably, 2500 Å.

The first thickness Ta may be about 900 Å to about 1200 Å, preferably, 1060 Å. The second thickness Tc may be about 1100 Å to about 1350 Å, preferably, 1220 Å. The third thickness Tb may be about 200 Å to about 310 Å, preferably, 260 Å. In this case, the thickness of the first hole transport layer 201 may be about 400 Å to about 600 Å, preferably, 500 Å.

An example of FIG. 6 and an example of FIG. 10 are compared with each other as follows.

The thickness of the first hole transport layer 201 of FIG. 6 may be about 810 Å, and the thickness of the first hole transport layer 201 of FIG. 10 may be about 500 Å. Thus, the thickness of the first hole transport layer 201 of FIG. 10 may be reduced by about 310 Å with respect to the thickness of the first hole transport layer 201 of FIG. 6. In FIG. 10, as the thickness of the first hole transport layer 201 has decreased, the second thickness Tc of the second optical auxiliary body 160C needs to increase.

The second thickness Tc of FIG. 6 may be about 960 Å, and the second thickness Tc of FIG. 10 may be about 1220 Å. Thus, the second thickness Tc of FIG. 10 increases by about 260 Å. When considering that the optical index of refraction of the optical auxiliary layer is about 1.5 and the optical index of refraction of the first hole transport layer 201 at about 460 nm is about 1.9, the reduction amount of the thickness of the first hole transport layer 201 and the increment of the second thickness Tc may satisfy the above-described [Equation 1].

As a result of numerical limitations to the thickness, the display apparatus according to some embodiments may implement a more efficient resonance structure compared to display apparatuses according to comparative examples to be described later. As a result, a display apparatus having high light efficiency may be provided.

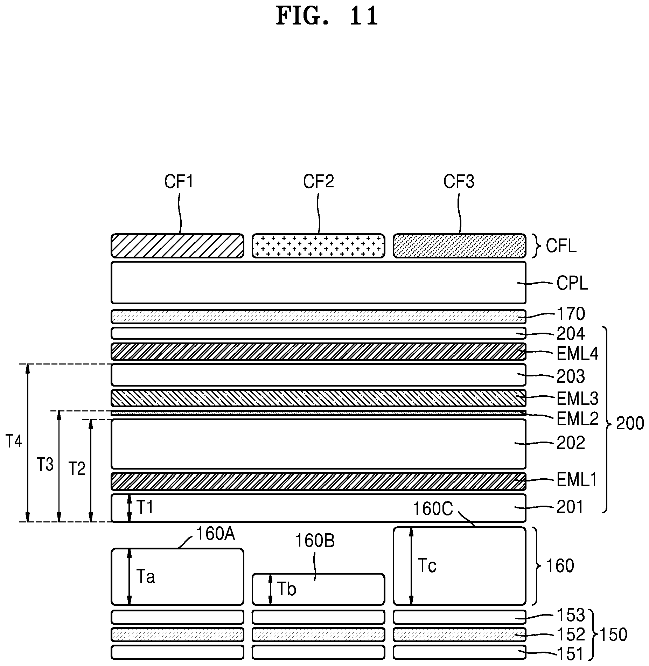

FIG. 11 is a cross-sectional view schematically illustrating another example of a stack structure of a pixel electrode, an optical auxiliary layer, an intermediate layer, a capping layer, and a color filter layer of FIG. 3. As a reference, the same or redundant descriptions as those given with reference to FIG. 11 may be omitted.

As shown in FIG. 11, the optical auxiliary layer may further include a third optical auxiliary body 160B that has the third thickness Tb and is located side-by-side with the above-described first optical auxiliary body 160A and the above-described second optical auxiliary body 160C. In this case, the third thickness Tb may be less than the first thickness Ta and the second thickness Tc.

For example, a difference between the third thickness Tb and the second thickness Tc may be about 900 Å to about 1020 Å. For example, a difference between the second thickness Tc and the third thickness Tb may be six times the difference between the first thickness Ta and the second thickness Tc. For example, in a plan view, the third optical auxiliary body 160B may overlap the second color filter CF2.

As shown in FIG. 11, the thickness of the first hole transport layer 201 may be less than the thickness of the first connection layer 202. In addition, the thickness of the first hole transport layer 201 may be greater than the thickness of the second connection layer 203.

An example including detailed numerical values is as below.

For example, a difference between the first thickness Ta of the first optical auxiliary body 160A and the second thickness Tc of the second optical auxiliary body 160C may be about 120 Å to about 180 Å, preferably, 160 Å. A difference between the second thickness Tc of the second optical auxiliary body 160C and the third thickness Tb of the third optical auxiliary body 160B may be about 900 Å to about 1020 Å, preferably, 960 Å. For example, the thickness of the intermediate layer 200 may be about 2200 Å to about 2800 Å, preferably, 2500 Å.

The first thickness Ta may be about 1200 Å to about 1500 Å, preferably, 1340 Å. The second thickness Tc may be about 1300 Å to about 1600 Å, preferably, 1480 Å. The third thickness may be about 400 Å to about 650 Å, preferably, 540 Å. In this case, the thickness of the first hole transport layer 201 may be about 200 Å to about 400 Å, preferably, 300 Å.

An example of FIG. 10 and an example of FIG. 11 are compared with each other as follows.

The thickness of the first hole transport layer 201 of FIG. 10 may be about 500 Å, and the thickness of the first hole transport layer 201 of FIG. 11 may be about 300 Å. Thus, the thickness of the first hole transport layer 201 of FIG. 11 may be reduced by about 200 Å with respect to the thickness of the first hole transport layer 201 of FIG. 10. In FIG. 11, as the thickness of the first hole transport layer 201 has decreased, the second thickness Tc of the second optical auxiliary body 160C needs to increase.

The second thickness Tc of FIG. 10 may be about 1220 Å, and the second thickness Tc of FIG. 11 may be about 1480 Å. Thus, the second thickness Tc of FIG. 11 increases by about 260 Å. When considering that the optical index of refraction of the optical auxiliary layer is about 1.5 and the optical index of refraction of the first hole transport layer 201 at about 460 nm is about 1.9, the reduction amount of the thickness of the first hole transport layer 201 and the increment of the second thickness Tc may satisfy the above-described [Equation 1].

As a result of numerical limitations to the thickness, the display apparatus according to some embodiments may implement a more efficient resonance structure compared to display apparatuses according to comparative examples to be described later. As a result, a display apparatus having high light efficiency may be provided.

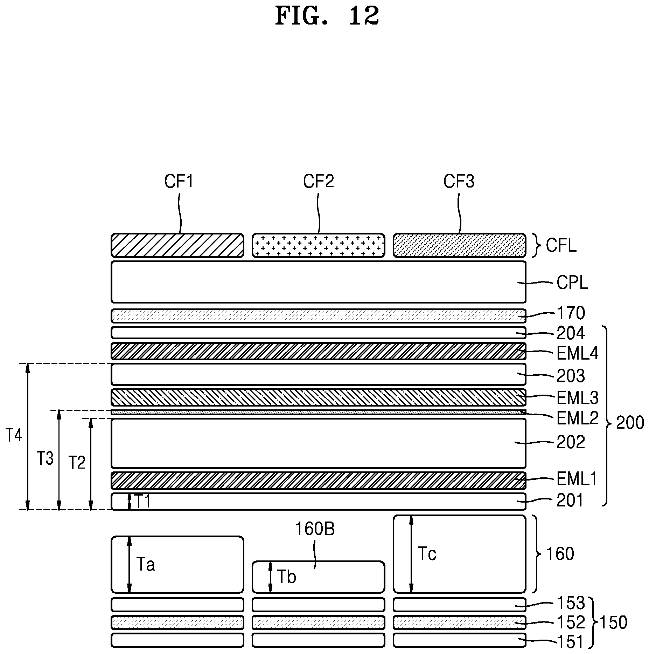

FIG. 12 is a cross-sectional view schematically illustrating another example of a stack structure of a pixel electrode, an optical auxiliary layer, an intermediate layer, a capping layer, and a color filter layer of FIG. 3. As a reference, the same or redundant descriptions as those given with reference to FIG. 12 may be omitted.

As shown in FIG. 12, the optical auxiliary layer may further include a third optical auxiliary body 160B that has the third thickness and is located side-by-side with the above-described first optical auxiliary body 160A and the above-described second optical auxiliary body 160C. In this case, the third thicknesss Tb may be less than the first thickness Ta and the second thickness Tc.

For example, a difference between the third thickness Tb and the second thickness Tc may be about 900 Å to about 1020 Å. For example, a difference between the second thickness Tc and the third thickness Tb may be six times the difference between the first thickness Ta and the second thickness Tc. For example, in a plan view, the third optical auxiliary body 160B may overlap the second color filter CF2.

As shown in FIG. 12, the thickness of the first hole transport layer 201 may be less than the thickness of the first connection layer 202. In addition, the thickness of the first hole transport layer 201 may be greater than the thickness of the second connection layer 203.

An example including detailed numerical values is as below.

For example, a difference between the first thickness Ta of the first optical auxiliary body 160A and a second thickness Tc of the second optical auxiliary body 160C may be about 120 Å to about 180 Å, preferably, 160 Å. A difference between the second thickness Tc of the second optical auxiliary body 160C and the third thickness Tb of the third optical auxiliary body 160B may be about 900 Å to about 1020 Å, preferably, 960 Å. For example, the thickness of the intermediate layer 200 may be about 2200 Å to about 2800 Å, preferably, 2500 Å.

The first thickness Ta may be about 1300 Å to about 1600 Å, preferably, 1480 Å. The second thickness Tc may be about 1600 Å to about 1900 Å, preferably, 1780 Å. The third thickness may be about 700 Å to about 900 Å, preferably, 820 Å. In this case, the thickness of the first hole transport layer 201 may be about 80 Å to about 120 Å, preferably, 100 Å.

An example of FIG. 11 and an example of FIG. 12 are compared with each other as follows.

The thickness of the first hole transport layer 201 of FIG. 11 may be about 300 Å, and the thickness of the first hole transport layer 201 of FIG. 12 may be about 100 Å. Thus, the thickness of the first hole transport layer 201 of FIG. 12 may be reduced by about 200 Å with respect to the thickness of the first hole transport layer 201 of FIG. 11. In FIG. 12, as the thickness of the first hole transport layer 201 has decreased, the second thickness Tc of the second optical auxiliary body 160C needs to increase.

The second thickness Tc of FIG. 11 may be about 1480 Å, and the second thickness Tc of FIG. 12 may be about 1780 Å. Thus, the second thickness Tc of FIG. 12 increases by about 300 Å. When considering that the optical index of refraction of the optical auxiliary layer is about 1.5 and the optical index of refraction of the first hole transport layer 201 at about 460 nm is about 1.9, the reduction amount of the thickness of the first hole transport layer 201 and the increase amount of the second thickness Tc may approximately satisfy the above-described [Equation 1].

As a result of numerical limitations to the thickness, the display apparatus according to some embodiments may implement a more efficient resonance structure compared to display apparatuses according to comparative examples to be described later. As a result, a display apparatus having high light efficiency may be provided.

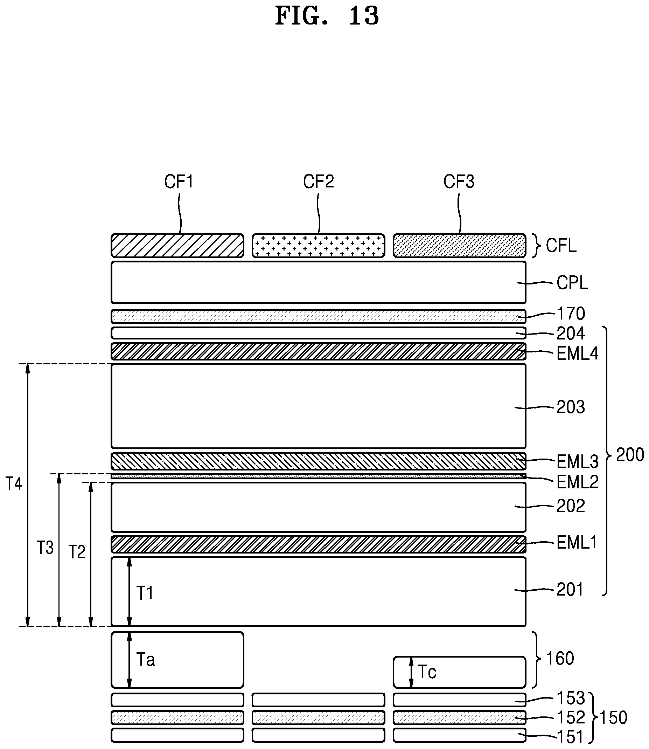

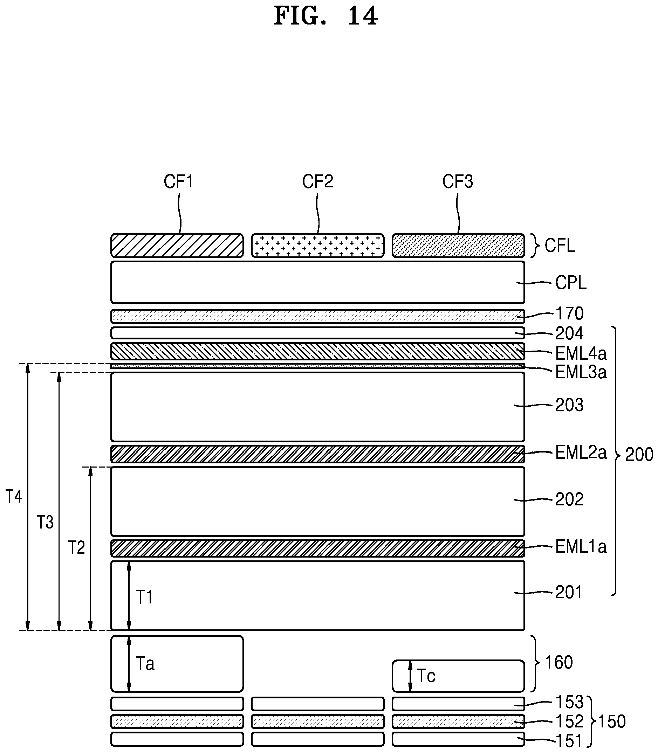

FIGS. 13 and 14 are cross-sectional views schematically illustrating examples of a cross-section corresponding to a stack structure of a pixel electrode, an optical auxiliary layer, an intermediate layer, a capping layer, and a color filter layer of FIG. 3, in a display apparatus according to a comparative example.

As shown in FIG. 13, in the display apparatus according to the comparative example, the thickness of the second connection layer 203 is greater than the thickness of the first connection layer 202, and the thickness of the intermediate layer 200 is remarkably greater than the thickness of the intermediate layer 200 of FIGS. 6, 10, 11, and 12 according to examples of the present disclosure so that light efficiency may be remarkably lowered. In addition, in the structure of FIG. 13, the first thickness Ta is greater than the second thickness Tc, and the arrangement of these optical auxiliary bodies may be disadvantageous in view of a resonance structure compared to the arrangement of the optical auxiliary bodies of FIGS. 6, 10, 11, and 12 according to the examples of the present disclosure.

As shown in FIG. 14, in the display apparatus according to another comparative example, a green-based emission layer and a red-based emission layer are not located between blue-based emission layers. In this case, the characteristics of blue-based visible light are greatly lowered, and the output of the blue-based visible light needs to increase so that the life-span of an organic material that emits the blue-based visible light may be reduced. In addition, in the structure of FIG. 14, the first thickness Ta is greater than the second thickness Tc, and the arrangement of these optical auxiliary bodies may be disadvantageous in view of a resonance structure compared to the arrangement of the optical auxiliary bodies of FIGS. 6, 10, 11, and 12 according to the examples of the present disclosure.

According to some embodiments having the configuration described above, a display apparatus having relatively high light efficiency may be implemented. Of course, the scope of the present disclosure is not limited by these effects.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims, and their equivalents.

**Claims**

1.   A display apparatus comprising:

a circuit layer on a substrate and comprising at least one thin-film transistor;
a pixel electrode on the circuit layer;
an intermediate layer on the pixel electrode, comprising a first emission layer configured to emit light in a first wavelength band, a second emission layer configured to emit light in a second wavelength band, a third emission layer configured to emit light in a third wavelength band, and a fourth emission layer configured to emit light in the first wavelength band, wherein the first through fourth emission layers overlap each other in a plan view;
an opposite electrode on the intermediate layer;
a color filter layer on the opposite electrode and comprising a first color filter through which light in the second wavelength band transmits, a second color filter side-by-side with the first color filter and through which light in the third wavelength band transmits, and a third color filter side-by-side with the second color filter and through which light in the first wavelength band transmits; and
an optical auxiliary layer between the pixel electrode and the intermediate layer, comprising a first optical auxiliary body having a first thickness and a second optical auxiliary body side-by-side with the first optical auxiliary body and having a second thickness greater than the first thickness, wherein the first optical auxiliary body and the first color filter overlap each other in the plan view, and the second optical auxiliary body and the third color filter overlap each other in the plan view.

2. The display apparatus of claim 1, wherein the intermediate layer further comprises a first hole transport layer between the pixel electrode and the first emission layer.

3. The display apparatus of claim 2, wherein a sum of an optical thickness of the first hole transport layer in the first wavelength band and an optical thickness of the second optical auxiliary body in the first wavelength band coincides with a sum of an optical thickness of the first hole transport layer in the second wavelength band and an optical thickness of the first optical auxiliary body in the second wavelength band.

4. The display apparatus of claim 2 or claim 3, wherein an optical thickness of the first hole transport layer in the first wavelength band is in inverse proportion to an optical thickness of the second optical auxiliary body in the first wavelength band.

5. The display apparatus of any one of claims 2 to 4, wherein a part of the first hole transport layer in the first wavelength band is replaceable with a part of the second optical auxiliary body in the first wavelength band, optionally wherein an optical thickness of a part of the first hole transport layer in the first wavelength band coincides with an optical thickness of a part of the second optical auxiliary body in the first wavelength band.

6. The display apparatus of any one of claims 1 to 5, wherein the pixel electrode comprises a reflective layer on the substrate and a first transparent conductive layer on the reflective layer, and the optical auxiliary layer is between the first transparent conductive layer and the intermediate layer, optionally wherein the pixel electrode further comprises a second transparent conductive layer under the reflective layer, and an upper surface of the second transparent conductive layer and a lower surface of the reflective layer are in contact with each other.

7. The display apparatus of any one of claims 1 to 6, wherein a difference between the second thickness and the first thickness is greater than a thickness of the first emission layer, optionally wherein a thickness of the first emission layer coincides with a thickness of the fourth emission layer.

8. The display apparatus of any one of claims 1 to 7, wherein the first wavelength band is a blue-based visible light region, the second wavelength band is a red-based visible light region, and the third wavelength band is a green-based visible light region.

9. The display apparatus of any one of claims 1 to 8, wherein a first connection layer is between the first emission layer and the second emission layer, and a second connection layer is between the third emission layer and the fourth emission layer.

10. The display apparatus of claim 9, wherein:

(i) a thickness of the first connection layer and a thickness of the second connection layer are greater than a thickness of the first emission layer; and/or
(ii) the first connection layer comprises a first electron transport layer on the first emission layer, a first charge generation layer on the first electron transport layer, and a second hole transport layer on the first charge generation layer, optionally wherein the second connection layer comprises a second electron transport layer on the third emission layer, a second charge generation layer on the second electron transport layer, and a third hole transport layer on the second charge generation layer.

11. The display apparatus of claim 9 or claim 10, wherein an upper surface of the second emission layer and a lower surface of the third emission layer are in contact with each other.

12. The display apparatus of any one of claims 1 to 11, wherein:

   (i) a capping layer is further between the opposite electrode and the color filter layer; and/or
   (ii) a difference between the second thickness and the first thickness is in a range of 120 Å to 180 Å.

13. The display apparatus of any one of claims 1 to 12, wherein the optical auxiliary layer further comprises a third optical auxiliary body having a third thickness and side-by-side with the first optical auxiliary body and the second optical auxiliary body.

14. The display apparatus of claim 13, wherein the third thickness is less than the first thickness and the second thickness.

15. The display apparatus of claim 14, wherein:

   (i) a difference between the third thickness and the second thickness is in a range of 900 Å to 1020 Å; and/or
   (ii) a difference between the second thickness and the third thickness is six times a difference between the first thickness and the second thickness.

16. The display apparatus of any one of claims 13 to 15, wherein, in the plan view, the third optical auxiliary body overlaps the second color filter.

17. The display apparatus of any one of claims 1 to 16, wherein a thickness of the intermediate layer is in a range of 2200 Å to 2800 Å.

# FIG. 1

10

100

PA

DA

PL    DL

SL

PX

y

x

z

# FIG. 2

# FIG. 3

# FIG. 4

200

| |
|---|
| — 204 |
| — EML4 |
| — 203C ⎫ |
| — 203B ⎬ 203 |
| — 203A ⎭ |
| — EML3 |
| — EML2 |
| — 202C ⎫ |
| — 202B ⎬ 202 |
| — 202A ⎭ |
| — EML1 |
| — 201 |

# FIG. 5

# FIG. 6

# FIG. 7

| Red | | | |
|---|---|---|---|
| Ta (Å) | T2 (Å) | Rx | Efficiency(%) |
| 700 | 1310 | 0.683 | 23.1 |
| | 1410 | 0.685 | 31.5 |
| | 1510 | 0.687 | 38.1 |
| | 1560 | 0.687 | 40.4 |
| | **1610** | **0.688** | **42.0** |
| | 1660 | 0.689 | 42.9 |
| | 1710 | 0.688 | 42.9 |

| 1st Blue | | | |
|---|---|---|---|
| Tc (Å) | T1 (Å) | By | Efficiency(%) |
| 960 | 460 | 0.033 | 4.9 |
| | 560 | 0.033 | 6.0 |
| | 660 | 0.034 | 7.0 |
| | 710 | 0.034 | 7.3 |
| | **760** | **0.035** | **7.5** |
| | 810 | 0.035 | 7.6 |
| | 860 | 0.035 | 6.7 |
| | 960 | 0.036 | 5.5 |

# FIG. 8

| Green | | | |
|---|---|---|---|
| Tb (Å) | T3 (Å) | Gx | Efficiency(%) |
| 0 | 1360 | 0.142 | 16.8 |
| | 1460 | 0.175 | 41.5 |
| | 1560 | 0.202 | 70.9 |
| | 1610 | 0.214 | 86.9 |
| | **1660** | **0.223** | **98.0** |
| | 1710 | 0.241 | 94.5 |
| | 1760 | 0.232 | 82.6 |

| 2nd Blue | | | |
|---|---|---|---|
| Tc (Å) | T4 (Å) | By | Efficiency(%) |
| 960 | 1825 | 0.033 | 5.2 |
| | 1925 | 0.034 | 6.6 |
| | 2025 | 0.034 | 7.4 |
| | **2075** | **0.033** | **7.5** |
| | 2125 | 0.035 | 7.5 |
| | 2175 | 0.034 | 6.6 |

FIG. 9

| T1 (Å) | Rx | R Efficiency(%) | Gx | G Efficiency(%) | By | B Efficiency(%) | W Efficiency(%) |
|---|---|---|---|---|---|---|---|
| 560 | 0.677 | 21.6 | 0.118 | 78.5 | 0.026 | 2.2 | 27.3 |
| 610 | 0.678 | 27.1 | 0.132 | 85.2 | 0.026 | 3.4 | 35.3 |
| 660 | 0.681 | 35.2 | 0.160 | 92.4 | 0.027 | 5.5 | 46.2 |
| 710 | 0.684 | 39.3 | 0.184 | 96.9 | 0.029 | 6.8 | 51.3 |
| **760** | **0.688** | **42.0** | **0.223** | **98.0** | **0.035** | **7.5** | **52.6** |
| 810 | 0.690 | 41.3 | 0.251 | 94.5 | 0.040 | 7.1 | 48.9 |
| 860 | 0.693 | 37.3 | 0.293 | 82.4 | 0.052 | 5.6 | 37.9 |
| 910 | 0.695 | 33.5 | 0.318 | 74.5 | 0.064 | 4.5 | 29.4 |
| 960 | 0.697 | 27.4 | 0.356 | 60.2 | 0.089 | 3.1 | 17.8 |

# FIG. 10

# FIG. 11

CF1      CF2      CF3

} CFL

CPL

~170

~204
EML4
~203
EML3
EML2
} 200
~202

EML1

T4   T3   T2   T1     160C     ~201

160A    160B

Ta   Tb   Tc   } 160

~153
~152 } 150
~151

# FIG. 12

CF1    CF2    CF3

} CFL

— CPL

— 170

— 204

— EML4

— 203

— EML3

— EML2

— 202

— EML1

— 201

} 200

T4  T3  T2  T1

160B

Ta    Tb    Tc

} 160

— 153
— 152
— 151
} 150

# FIG. 13

# FIG. 14

CF1  CF2  CF3

} CFL

CPL

170

204
EML4a
EML3a

203

EML2a  } 200

202

EML1a

201

T4  T3  T2  T1

Ta

Tc  } 160

153
152  } 150
151

Europäisches
Patentamt

European
Patent Office

Office européen
des brevets

## EUROPEAN SEARCH REPORT

**Application Number**

EP 24 17 9135

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2012/206675 A1 (SEO SATOSHI [JP] ET AL) 16 August 2012 (2012-08-16) | 1,2,7,8, 13-15,17 | INV. H10K50/19 |
| A | * paragraphs [0047] - [0049], [0067] * | 3-5,16 | H10K50/818 |
| | * paragraphs [0063] - [0086] * | | H10K50/852 |
| | * paragraphs [0093] - [0107] * | | H10K59/35 |
| | * paragraphs [0144], [0164], [0167] * | | H10K59/38 |
| | * paragraph [0209] * | | H10K59/80 |
| | * table 2 * | | H10K50/13 |
| | * figures 3B, 4A, 5A, 5B * | | |
| | ----- | | ADD. |
| Y | US 2022/209191 A1 (JOUNG SEUNGRYONG [KR] ET AL) 30 June 2022 (2022-06-30) | 1,2,6,8, 12 | H10K102/00 |
| A | * paragraphs [0055] - [0085] * | 3-5,16 | |
| | * paragraph [0237] * | | |
| | * figure 1 * | | |
| | ----- | | |
| Y | US 2022/208888 A1 (BYEON HEESU [KR] ET AL) 30 June 2022 (2022-06-30) | 1,2,6, 8-12 | |
| A | * paragraphs [0072], [0079], [0086] * | 3-5,16 | |
| | * paragraphs [0092], [0123], [0125] * | | |
| | * figure 4 * | | TECHNICAL FIELDS SEARCHED (IPC) |
| | ----- | | |
| Y | US 2023/217671 A1 (CHAE HEE YOUNG [KR] ET AL) 6 July 2023 (2023-07-06) | 1,2,8-11 | H10K |
| A | * paragraphs [0051] - [0058] * | 3-5,16 | |
| | * figure 1 * | | |
| | ----- | | |
| Y | US 2021/159462 A1 (HAMER JOHN [US] ET AL) 27 May 2021 (2021-05-27) | 1,2,8-11 | |
| A | * paragraphs [0060], [0112] * | 3,5,16 | |
| | ----- | | |

The present search report has been drawn up for all claims

| Place of search | Date of completion of the search | Examiner |
|---|---|---|
| Munich | 30 September 2024 | Pfattner, Raphael |

EPO FORM 1503 03.82 (P04C01)

## ANNEX TO THE EUROPEAN SEARCH REPORT
## ON EUROPEAN PATENT APPLICATION NO.

EP 24 17 9135

This annex lists the patent family members relating to the patent documents cited in the above-mentioned European search report.
The members are as contained in the European Patent Office EDP file on
The European Patent Office is in no way liable for these particulars which are merely given for the purpose of information.

30-09-2024

| Patent document cited in search report | Publication date | Patent family member(s) | | Publication date |
|---|---|---|---|---|
| US 2012206675 A1 | 16-08-2012 | JP | 2012182127 A | 20-09-2012 |
| | | JP | 2016195136 A | 17-11-2016 |
| | | KR | 20120092507 A | 21-08-2012 |
| | | US | 2012206675 A1 | 16-08-2012 |
| US 2022209191 A1 | 30-06-2022 | KR | 20220095032 A | 06-07-2022 |
| | | US | 2022209191 A1 | 30-06-2022 |
| US 2022208888 A1 | 30-06-2022 | CN | 114695471 A | 01-07-2022 |
| | | JP | 2022105288 A | 13-07-2022 |
| | | JP | 2023153822 A | 18-10-2023 |
| | | KR | 20220096979 A | 07-07-2022 |
| | | US | 2022208888 A1 | 30-06-2022 |
| US 2023217671 A1 | 06-07-2023 | CN | 116390515 A | 04-07-2023 |
| | | US | 2023217671 A1 | 06-07-2023 |
| US 2021159462 A1 | 27-05-2021 | CN | 113272990 A | 17-08-2021 |
| | | EP | 4066294 A1 | 05-10-2022 |
| | | JP | 7495401 B2 | 04-06-2024 |
| | | JP | 2023530043 A | 13-07-2023 |
| | | KR | 20220109306 A | 04-08-2022 |
| | | US | 2021159462 A1 | 27-05-2021 |
| | | WO | 2021108298 A1 | 03-06-2021 |

For more details about this annex : see Official Journal of the European Patent Office, No. 12/82